# EUROPÄISCHE PATENTSCHRIFT

(11) **EP 0 321 743 B1**
(45) Veröffentlichungstag und Bekanntmachung des Hinweises auf die Patenterteilung: **28.02.1996**
(21) Anmeldenummer: 88119912.9
(22) Anmeldetag: 29.11.1988
(51) Int. Cl.: H01R 9/24, H02G 15/076, H04Q 1/14, H01R 4/24

(54) **Anschlussleiste für ankommende und abgehende elektrische Leitungen**
Connection strip for incoming and outgoing electrical lines
Réglette de raccordement pour lignes électriques de départ et d'arrivée

(30) Priorität: 23.12.1987 DE 8716919 U
(43) Veröffentlichungstag der Anmeldung: 28.06.1989
(73) Patentinhaber: SIEMENS AKTIENGESELLSCHAFT, D-80333 München (DE)
(72) Erfinder: Scholtholt, Hans, Ing. grad, D-8044 Lohof (DE); Steiner, Ewald, Ing. grad., D-8137 Berg 3 (DE)

(56) Entgegenhaltungen:
- EP-A- 0 243 296
- DE-A- 3 621 223
- FR-A- 2 286 520

## Beschreibung

Die Erfindung bezieht sich auf eine Anschlußleiste mit zwei Reihen von Anschlußelementen jeweils für ankommende und abgehende elektrische Leitungen insbesondere von Fernsprechanlagen.

Eine derartige Anschlußleiste ist z. B. durch die DE-OS 27 25 551 bekannt geworden. Danach weisen die Anschlußelemente in die gleiche Richtung und sind in einem Isolierstoffkörper der Anschlußleiste eingebettet. Die Anschlußelemente sind als Schneidklemmen ausgebildet, deren Kontaktstellen in einer Ebene liegen. D. h., daß die ankommenden und abgehenden Leitungen von der gleichen Seite her in die Klemmschlitze der Schneidklemmen eingedrückt werden. Die Leitungen werden von den Anschlußstellen aus über die benachbarten Seitenkanten der Anschlußleiste entlang den sich daran anschließenden Seitenflächen von den Kontaktelementen weggeführt. Eine weitere derartige Anschlußleiste ist durch die EP-A-0 243 296 bekannt geworden.

Derartige Anschlußleisten werden z. B. in Linienverzweigern von Fernsprechnetzen eingesetzt. Dabei sind die vom Amt kommenden Leitungen in Kabeln zusammengefaßt und an eine Reihe der Anschlußelemente angeschlossen. Die abgehenden Leitungen sind an die andere Reihe von Anschlußelementen angeschlossen. Die beiden Reihen von Anschlußelementen sind einstückig über einen Verbindungsabschnitt miteinander verbunden. Die abgehenden Leitungen sind Rangierdrähte, die zu den Teilnehmerleitungen führen. D. h., daß diese Leitungen auch nach dem Einbau der Anschlußleisten für Verdrahtungsänderungen zugänglich sein müssen. Daher werden die abgehenden Leitungen über die schmalen Stirnseiten der Anschlußleiste weggeführt. Die aus Kabeln ankommenden Leitungen werden von der den Anschlußstellen abgewandten Unterseite an die Anschlußelemente herangeführt.

Der Erfindung liegt die Aufgabe zugrunde, die Anschlußleisten in möglichst engem Teilungsabstand aneinander zu reihen und das Anschließen der Schaltdrähte zu erleichtern.

Diese Aufgabe wird durch die Erfindung gemäß Anspruch 1 gelöst. Danach wird der zwischen den Anschlußreihen zu Verfügung stehende Raum maximal ausgenutzt. Die Anschlußleisten können nun mit geringem seitlichen Abstand aneinander gereiht werden. Dabei werden die ankommenden Leitungen jeweils an der zuletzt angesetzte Anschlußleiste fixiert, bevor die nächste Anschlußleiste angebracht wird. Es ist üblich, zwischen den Reihen der Anschlußelemente Steckkontaktstellen z.B. für Schutzstecker vorzusehen, die einen entsprechenden Raum benötigen. Ferner muß für das Ansetzen der Verdrahtungswerkzeuge ein entsprechender Freiraum geschaffen werden. Nach der Erfindung liegt der zu den Stirnseiten der Anschlußleiste führende kanalartige Verdrahtungsraum zwischen den beiden Anschlußelementereihen. Das bedeutet, daß die Schaltdrähte von der gleichen Seite her an die Anschlußelemente angeschlossen werden. Da die Anschlußleisten üblicherweise senkrecht übereinander angeordnet werden, hängen die zunächst überstehenden Enden nach unten, was die Übersichtlichkeit erhöht und das Anschließen erleichtert. Das Anschlußwerkzeug wird bei beiden Reihen von Anschlußelementen in derselben Stellung gehalten. Die überstehenden Drahtenden fallen nach dem Abschneiden ungehindert nach unten.

Durch der Erfindung nach Anspruch 1 kann der kanalartige Verdrahtungsraum für die abgehenden Leitungen besonders breit gehalten werden.

Im folgenden wird die Erfindung anhand eines in der Zeichnung dargestellten Ausführungsbeispiels näher erläutert.

Die Figuren 1, 2 und 3 zeigen in drei verschiedenen Seitenansichten einen Verteilerblock mit aneinander gereihten Anschlußleisten für ankommende und abgehende Leitungen.

Figur 4 stellt einen Querschnitt durch eine Anschlußleiste dar.

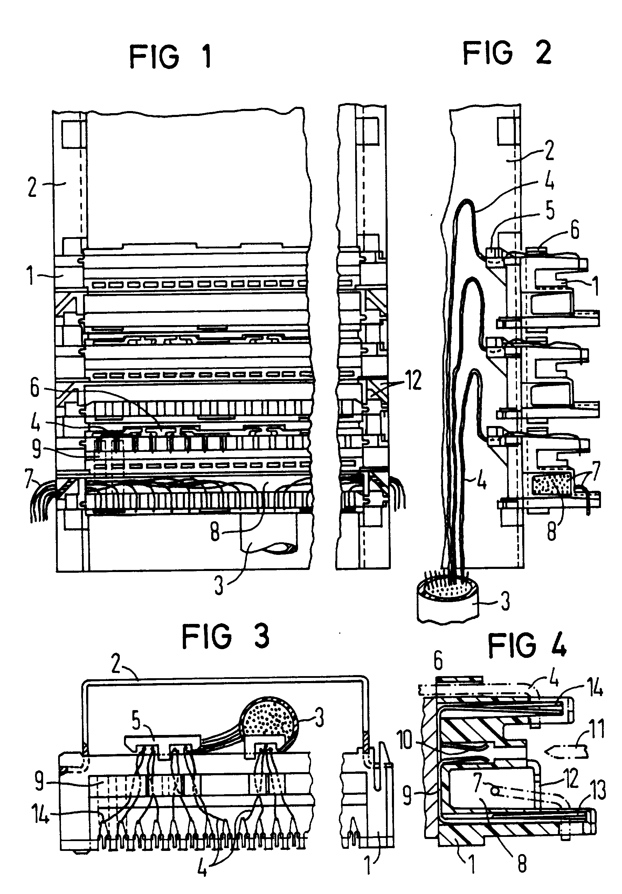

Nach den Figuren 1, 2 und 3 sind Anschlußleisten 1 für elektrische Leitungen längsseitig aneinander gereiht an einem u-förmig gebogenen Trägerblech befestigt. Aus einem Kabel 3 ankommende elektrische Leitungen 4 sind zwischen den Anschlußleisten 1 und dem Basisabschnitt des Trägerblechs 2 durch Drahtführungsösen 5, 6 an eine Reihe von Anschlußstellen der Anschlußleisten 1 herangeführt.

Abgehende Leitungen 7 in Form von Rangierdrähten sind an eine zweite Reihe von Anschlußstellen der Anschlußleisten 1 angeschlossen. Von dort führen sie über einen kanalartigen Verdrahtungsraum 8 der Verteilerleiste 1 zu deren Stirnseiten, von wo aus sie zu anderen Anschlußleisten geführt sind.

In Figur 4 ist der Aufbau der Anschlußleiste genau dargestellt. U-förmig gebogene Kontaktteile 9 bilden an den Enden ihrer Seitenschenkel die Anschlußstellen für die ankommenden Leitungen 4 und die abgehenden Leitungen 7. Aus dem Basisabschnitt der Kontaktteile 9 sind federnde Lappen als Kontaktfedern 10 hochgebogen. Zwischen diese können stiftförmige Steckereinrichtungen 11 z. B. eines Schutzsteckers kontaktgebend eingeschoben werden. Die Kontaktfedern 10 sind zu den Seitenschenkeln für die ankommenden Leitungen 4 hin verlagert, so daß sich der Abstand zwischen den Kontaktfedern 10 und den Seitenschenkeln für die abgehenden Leitungen 7 entsprechend vergrößert. Die tiefe Ausnehmung zwischen diesen bildet den kanalartigen Verdrahtungsraum 8, der durchgehend von einer zur anderen Stirnseite der Anschlußleiste 1 verläuft. An beiden Stirnseiten ist der Verdrahtungsraum von geschlitzten Lappen 12 überdeckt, die eine Führungshilfe darstellen. Die ankommenden Leitungen 4 sind von der Außenseite der Anschlußleiste 1 an die Kontaktstücke 9 angeschlossen. Die abgehenden Leitungen 7 sind von den Stirnseiten der Anschlußleiste 1 durch den Verdrahtungsraum 8 zu den einzelnen Kontaktstellen geführt und somit von innen her an die Seitenschenkel der Kontaktstücke 9 herangeführt. Diese bilden Anschlußelemente 14, 13 in Form von Schneidklemmen. In diese werden die ankommenden und abgehenden Leitungen 4,7 von oben her eingedrückt und dadurch kontaktiert.

## Patentansprüche

1. Anschlußleiste (1) mit zwei Reihen von Anschlußelementen (12, 13) jeweils für ankommende und abgehende elektrische Leitungen (4, 7) insbesondere von Fernsprechanlagen, wobei die Anschlußelemente (12, 13) in die gleiche Richtung weisen und in einem Isolierstoffkörper der Anschlußleiste (1) eingebettet sind, wobei zumindest die in einem Kabel (3) ankommenden Leitungen (4) von der Außenseite der Anschlußleiste (1) her an die Anschlußelemente (12) herangeführt sind, wobei die Anschlußleiste (1) mit Steckkontaktstellen (z.B. 10) versehen ist, die zwischen den beiden Reihen von Anschlußelementen (12, 13) angeordnet und von derselben Seite her zugänglich sind wie die Anschlußelemente (12, 13),
**dadurch gekennzeichnet,**
daß die Steckkontaktstellen den Anschlußelementen (12) für die ankommenden Leitungen (4) benachbart sind und daß zwischen den Steckkontaktstellen (z.B. 10) und den Anschlußelementen (13) für die abgehenden Leitungen im Isolierstoffkörper ein kanalartiger Verdrahtungsraum (8) vorgesehen ist, in dem die abgehenden Leitungen (7) von den zugehörigen Anschlußelementen (13) zu den Stirnseiten der Anschlußleiste (1) geführt sind.

## Claims

1. Terminal strip (1) having two rows of connection elements (12, 13) in each case for incoming and outgoing electric lines (4, 7), in particular of telephone installations, the connection elements (12, 13) pointing in the same direction and being embedded in an insulator of the terminal strip (1), at least the lines (4) incoming in a cable (3) being led from the outside of the terminal strip (1) to the connection elements (12), the terminal strip (1) being provided with plug contact points (e.g. 10) which are arranged between the two rows of connection elements (12, 13) and are accessible from the same side as the connection elements (12, 13), characterized in that the plug contact points are adjacent to the connection elements (12) for the incoming lines (4) and in that there is provided, between the plug contact points (e.g. 10) and the connection elements (13), a channel-like wiring space (8) in the insulator for the outgoing lines, in which space the outgoing lines (7) are led from the associated connection elements (13) to the ends of the terminal strip (1).

## Revendications

1. Réglette (1) de connexion comportant deux rangées d'éléments (12,13) de raccordement prévus respectivement pour des lignes (4,7) électriques d'arrivée et de départ notamment d'installations téléphoniques, dans laquelle les éléments (12,13) de raccordement sont dirigés suivant la même direction et sont incorporés dans un corps isolant de la réglette (1) de connexion, au moins les lignes (4) d'arrivée, arrivant dans un câble (3), s'étendant de la face extérieure de la réglette (1) de connexion jusqu'aux éléments (12) de raccordement, et la réglette (1) de connexion est munie de points (par exemple 10) de contact à enfichage, qui sont disposés entre les deux rangées d'éléments (12,13) de raccordement et sont accessibles à partir du même côté que le sont les éléments (12,13) de raccordement,
caractérisée par le fait
que les points de contact à enfichage sont voisins des éléments (12) de raccordement pour les lignes (4) d'arrivée, et qu'entre les points (par exemple 10) de contact à enfichage et les éléments (13) de raccordement pour les lignes de départ est prévu, dans le corps isolant, une zone (8) de câblage en forme de canal, dans laquelle les lignes (7) de départ s'étendent des éléments (13) de raccordement associés jusqu'aux faces frontales de la réglette (1) de connexion.
